(19) Europäisches Patentamt
European Patent Office
Office européen des brevets

(11) **EP 4 764 536 A1**

(12) **EUROPEAN PATENT APPLICATION**
published in accordance with Art. 153(4) EPC

(43) Date of publication:
**24.06.2026 Bulletin 2026/26**

(21) Application number: **24874845.1**

(22) Date of filing: **02.08.2024**

(51) International Patent Classification (IPC):
*G01R 31/385* (2019.01)    *G01R 19/165* (2006.01)
*G01R 19/10* (2006.01)    *G01R 35/00* (2006.01)

(52) Cooperative Patent Classification (CPC):
**G01R 19/10; G01R 19/165; G01R 31/385;
G01R 35/00; Y02E 60/10**

(86) International application number:
**PCT/KR2024/011412**

(87) International publication number:
**WO 2025/075286 (10.04.2025 Gazette 2025/15)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **05.10.2023 KR 20230132579**

(71) Applicant: **LG Energy Solution, Ltd.
Seoul 07335 (KR)**

(72) Inventor: **KIM, Min Woo
Daejeon 34122 (KR)**

(74) Representative: **Plasseraud IP
104 Rue de Richelieu
CS92104
75080 Paris Cedex 02 (FR)**

(54) **METHOD FOR MEASURING AND DIAGNOSING BATTERY CELL VOLTAGE**

(57)    The present invention provides a method for diagnosing measurement of a battery cell voltage including a process of calculating a voltage across a path resistor connected to an output path of a battery cell to be diagnosed, a process of comparing a voltage of the battery cell to be diagnosed with a voltage of a next adjacent battery cell, and a process of diagnosing an error in measurement according to the comparison result and a value of the voltage across the path resistor.

**FIG. 2**

# EP 4 764 536 A1

**Description**

## TECHNICAL FIELD

The present invention relates to a battery cell voltage measurement circuit, and more particularly, to a method for diagnosing measurement of a battery cell voltage for diagnosing an error in measurement of the battery cell voltage measurement circuit.

## BACKGROUND ART

A secondary battery capable of charging and discharging, that is, a battery, is widely used as an energy source for mobile devices such as smart phones. Furthermore, the battery is used as an energy source for eco-friendly vehicles such as an electric vehicle and a hybrid electric vehicle proposed as a solution to air pollution caused by a gasoline vehicle and a diesel vehicle using fossil fuels. The types of applications using the battery are becoming very diverse, and it is expected that the battery will be applied to more fields and products than now in the future.

Currently commercialized available batteries include a nickel cadmium battery, a nickel hydrogen battery, a nickel zinc battery, and a lithium ion battery. Among these batteries, the lithium ion battery is spotlighted due to their advantages of free charge and discharge, very low self-discharge rate, and high energy density because the memory effect hardly occurs compared to the nickel-based battery. In addition, since the lithium ion battery can be manufactured to be lightweight in a small size, the lithium ion battery is used as a power source for mobile devices, and the use range thereof has been expanded as a power source for the electric vehicle, thereby drawing attention as a next-generation energy storage medium.

These batteries are generally used in the form of a battery pack rather than as a single battery cell. The battery pack includes at least one or more battery modules, and the battery module may be composed of a plurality of battery cells. The battery pack has been developed in high capacity and high voltage specifications so that it can be used longer and driven more powerfully in response to consumer demands. For example, as requirements for electric vehicles such as driving range and maximum output increase, the number of battery modules and battery cells that make up a battery pack is increasing. Meanwhile, a battery management system (BMS) is provided to manage the overall state of battery cells, battery modules, or battery packs.

However, in the case of a battery in which a plurality of battery cells are connected, when charge and discharge of the battery is repeated, an imbalance in a charge amount of each battery cell occurs. When discharge of the battery continues in this state of imbalance in the charge amount, a specific battery cell with a low charge amount is overdischarged, thereby making stable operation of the battery difficult. In contrast, when charge of the battery continues in the state of imbalance in the charge amount, a specific battery cell with a high charge amount is overcharged, thereby impairing the safety of the battery. For example, when any one battery cell is in a state having the lowest charge voltage and any other battery cell is in a state having the highest charge voltage, a problem may occur in which the battery cannot be charged as well as discharged even if all other battery cells have an appropriate charge voltage. As such, the imbalance in the charge amount may cause some battery cells to be in an overcharged or overdischarged state, and this problem causes a problem of not being able to stably supply power to the load. In addition, overcharge or overdischarge of a specific battery cell may cause a problem in which not only a capacity of a battery pack decreases, but also the battery pack degrades and the lifespan of the battery pack is shortened. Therefore, it is important to accurately measure a battery cell voltage. That is, accurate measurement of the battery cell voltage is essential to determine the state of each battery cell within a limited space and control the battery cell according to the determined state. When the battery cell voltage is measured abnormally, not only may a normal diagnosis function not be performed or but a problem may occur in the performance of SOX (battery performance indicators such as state of charge (SOC), state of health (SOH), etc.) estimation.

Meanwhile, when a measurement circuit is abnormal, the battery cell voltage may be measured abnormally. Therefore, it is necessary to diagnose whether the battery cell voltage has been accurately measured using the measurement circuit. Conventionally, voltages of lines connected to the battery cell were compared with each other to diagnose the measurement of the battery cell voltage. That is, the voltages measured on two lines connected in parallel with the battery cell are compared with each other, and when a difference between the voltages measured on the lines is larger than a certain level, it is determined that there is a problem with the battery cell voltage measurement circuit. However, the conventional method has a problem in that it cannot diagnose an abnormality in the battery cell voltage measurement circuit when both lines are abnormal.

Examples of the related art include Korean registered patent No. 10-1610908 and Korean unexamined patent publication No. 10-2023-0108604.

## DISCLOSURE OF THE INVENTION

## TECHNICAL PROBLEM

The present invention provides a method for diagnosing measurement of a battery cell voltage in which a battery cell voltage measurement circuit can be diagnosed.

The present invention provides a method for diagnosing measurement of a battery cell voltage for comparing a voltage of a battery cell to be diagnosed with a voltage of a next adjacent battery cell and diagnosing a battery cell voltage measurement circuit according to the comparison result and a value of a voltage across a path resistor of the battery cell to be diagnosed.

## TECHNICAL SOLUTION

A method for diagnosing measurement of a battery cell voltage according to embodiments of the present invention comprises a process of calculating a voltage across a path resistor connected to an output path of a battery cell to be diagnosed, a process of comparing a voltage of the battery cell to be diagnosed with a voltage of a next adjacent battery cell, and a process of diagnosing an error in measurement according to the comparison result and a value of the voltage across the path resistor.

The voltage across the path resistor is calculated from a difference between a voltage measured in a state that a balancing path of the battery cell to be diagnosed is set and a voltage measured in a state that the balancing path thereof is not set.

When the voltage of the battery cell to be diagnosed is greater than the voltage of the next adjacent battery cell and the voltage across the path resistor is a positive value, the measurement is diagnosed as normal, and when the voltage of the battery cell to be diagnosed is less than the voltage of the next adjacent battery cell and the voltage across the path resistor is a negative value, the measurement is diagnosed as normal.

The remaining cases except for a case where the measurement is diagnosed as normal according to the comparison result of the voltage of the battery cell to be diagnosed and the voltage of the next adjacent battery cell and the value of the voltage across the path resistor are diagnosed as an error in measurement.

A method for diagnosing measurement of a battery cell voltage according to other embodiments of the present invention is a method for diagnosing measurement of a battery cell voltage of a battery pack including a plurality of battery cells and a BMS, and comprises a process of calculating a voltage across a path resistor connected to an output path of a battery cell to be diagnosed from a voltage at an output end of the output path, a process of comparing a voltage of the battery cell to be diagnosed with a voltage of the next adjacent battery cell, and diagnosing measurement as normal when the comparison result and the voltage across the path resistor are included in set values, and a process of diagnosing that it is an error in voltage measurement when the measurement is not diagnosed as normal.

The voltage across the path resistor is calculated from a difference between a voltage when balancing of the battery cell to be diagnosed is performed and a voltage when the balancing thereof is not performed.

When the voltage of the battery cell to be diagnosed $V_{BC1}$, the voltage of the next adjacent battery cell $V_{BC2}$, and the voltage across the path resistor voltage V11 satisfy a condition that if $V_{BC1} > V_{BC2}$, then V11 > 0, or satisfy a condition that if $V_{BC1} < V_{BC2}$, then V11 < 0, the measurement is diagnosed as normal, and otherwise, it is diagnosed as an error in measurement.

## ADVANTAGEOUS EFFECTS

In the method for diagnosing measurement of a battery cell voltage according to embodiments of the present invention, the voltage of the battery cell to be diagnosed is compared with the voltage of the next adjacent battery cell, and an error in measurement is diagnosed according to the comparison result and the voltage across the path resistor of the battery cell to be diagnosed. That is, when the voltage of the battery cell to be diagnosed is greater than the voltage of the next adjacent battery cell, if the voltage across the path resistor is positive, the measurement is diagnosed as normal, and if it is a negative value, it is diagnosed as an error in measurement. When the battery cell voltage to be diagnosed is less than the voltage of the next adjacent battery cell, if the voltage across the path resistor is negative, the measurement is diagnosed as normal, and if it is a positive value, it is diagnosed as an error in measurement. In this case, the voltage across the path resistor can be calculated as a difference between the voltage across the path resistor when balancing of the battery cell to be diagnosed is performed and the voltage across the path resistor when balancing thereof is not performed.

As described above, in the present invention, by comparing the voltage of the battery cell to be diagnosed with the voltage of the next adjacent battery cell and diagnosing an error in measurement based on the value of the voltage across the path resistor, the error in measurement can be diagnosed even when both lines connected to one terminal of the battery cell are abnormal or one of the two lines is abnormal. That is, according to the present invention, it is possible to solve the problem of the conventional method of not being able to diagnose an abnormality in the battery cell voltage measurement circuit when both lines connected to one terminal of the battery cell are abnormal.

**EP 4 764 536 A1**

## BRIEF DESCRIPTION OF THE DRAWINGS

FIG. 1 is a circuit diagram of a circuit for diagnosing measurement of a battery cell voltage according to an embodiment of the present invention.
FIG. 2 is a flowchart of a method for diagnosing measurement of a battery cell voltage according to an embodiment of the present invention.
FIGS. 3 and 4 are circuit diagrams for describing an operation according to a method for diagnosing measurement of a battery cell voltage of the present invention.
FIG. 5 is a block diagram of a device for diagnosing measurement of a battery cell voltage according to an embodiment of the present invention.

## MODE FOR CARRYING OUT THE INVENTION

Hereinafter, embodiments of the present disclosure will be described in detail with reference to the accompanying drawings. However, the present disclosure is not limited to the embodiments disclosed below, but will be implemented in a variety of different forms, and these embodiments are provided only to complete the disclosure of the present disclosure and to fully inform those skilled in the art of the scope of the invention.

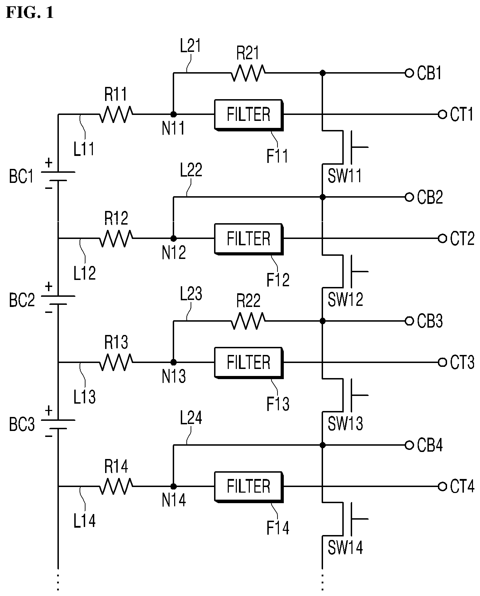

FIG. 1 is a circuit diagram of a method for diagnosing measurement of a battery cell voltage according to an embodiment of the present invention.

Referring to FIG. 1, a circuit for diagnosing measurement of a battery cell voltage according to an embodiment of the present invention may include a plurality of battery cells BC1, BC2, BC3, ..., a plurality of first lines L11, L12, L13, and L14 and plurality of second lines L21, L22, L23, and L24 that are respectively connected to positive terminals (+) and negative terminals (-) of a plurality of battery cells BC1, BC2, and BC3, a plurality of first resistors R11, R12, R13, and R14 and plurality of filters F11, F12, F13, and F14 that are respectively provided on the plurality of first lines L11, L12, L13, and L14, a plurality of second resistors R21 and R22 that are selectively provided on the plurality of second lines L21, L22, L23, and L24, and a plurality of switches SW11, SW12, SW13, and SW14 that connect adjacent second lines L21, L22, L23, and L24 with each other. In addition, a plurality of first measurement pins CT1, CT2, CT3, and CT4 may be respectively provided at respective ends of the plurality of first lines L11, L12, L13, and L14, and a plurality of second pins CB1, CB2, CB3, and CB4 may be respectively provided at respective ends of the plurality of second lines L21, L22, L23, and L24.

The positive terminals (+) and negative terminals (-) of the plurality of battery cells BC1, BC2, and BC3 are connected to the first line L11, L12, L13, and L14 and the second line L21, L22, L23, and L24. In this case, the first lines L11, L12, L13, and L14 and the second lines L21, L22, L23, and L24 are respectively connected in parallel with each other. That is, the positive terminal (+) of the first battery cell BC1 is connected to a (1-1)-th line L11 and a (2-1)-th line L21 that are connected in parallel with each other, and the negative terminal (-) of the first battery cell BC1 is connected to a (1-2)-th line L12 and a (2-2)-th line L22 that are connected in parallel with each other. In addition, the positive terminal (+) of the second battery cell BC2 is connected to the (1-2)-th line L12 and the (2-2)-th line L22 that are connected in parallel with each other. The negative terminal (-) of the second battery cell BC2 is connected to a (1-3)-th line L13 and a (2-3)-th line L23 that are connected in parallel with each other. In addition, the positive terminal (+) of the third battery cell BC3 is connected to the (1-3)-th line L13 and the (2-3)-th line L23 that are connected in parallel with each other, and the negative terminal (-) of the third battery cell BC3 is connected to a (1-4)-th line L14 and a (2-4)-th line L24 that are connected in parallel with each other. That is, the first and second lines connected to a negative terminal (-) of one battery cell are connected to a positive terminal (+) of another battery cell adjacent thereto. In other words, the negative terminals and positive terminals of two adjacent battery cells share the first and second lines.

The first resistors R11, R12, R13, and R14 and filters F11, F12, F13, and F14 are connected in series to the first lines L11, L12, L13, and L14, respectively, and the second resistors R21 and R22 are selectively connected to the second lines L21, L22, L23, and L24. A (2-1)-th resistor R21 is connected to the (2-1)-th line L21, and a (2-2)-th resistor R22 is connected to the (2-3)-th line L23. The second resistors R21 and R22 are alternately connected to the plurality of second lines L21, L22, L23, and L24. In other words, the second resistors R21 and R22 are connected to odd-numbered second lines L21 and L23 and are not connected to even-numbered second lines L22 and L24, among the plurality of second lines L21, L22, L23, and L24. Of course, the second resistors R21 and R22 may be connected to the even numbered second lines L22 and L24 and may not be connected to the odd-numbered second lines L21 and L23, among the plurality of second lines L21, L22, L23, and L24. Meanwhile, the second lines L21, L22, L23, and L24 may respectively branch from the first lines L11, L12, L13, and L14. For example, the second lines L21, L22, L23, and L24 may respectively branch from the nodes N11, N12, N13, and N14 between the first resistors R11, R12, R13, R14 and the filters F11, F12, F13, and F14. In addition, the first measurement pins CT1, CT2, CT3, and CT4 may be respectively provided on the first lines L11, L12, L13, and L14, and the second measurement pins CB1, CB2, CB3, and CB4 may be respectively provided on the second lines L21, L22, L23, and L24. That is, a (1-1)-th measurement pin CT1 and a (2-1)-th measurement pin CB1 are provided on the (1-1)-th line L11 and the (2-1)-th line L21 that are connected in parallel with each other, respectively, a (1-2)-th measurement pin CT2 and a (2-2)-th measurement pin CB2 are provided on the (1-2)-th line L12 and the (2-2)-th line L22 that are connected in parallel with each other, respectively, and a (1-3)-th measurement pin CT3 and a (2-3)-th measurement pin CB3 are provided on the (1-3)-th line L13 and the (2-3)-th line L23 that are connected in parallel with each other, respectively.

In addition, the second lines L21, L22, L23, and L24 may be connected by the switches SW11, SW12, SW13, and SW14. That is, a first switch SW11 may be provided between the (2-1)-th line L21 and the (2-2)-th line L22, a second switch SW12 may be provided between the (2-2)-th line L22 and the (2-3)-th line L23, and a third switch SW13 may be provided between the (2-3)-th line L23 and the (2-4)-th line L24. The switches SW11, SW12, and SW13 may be turned on or off according to a control signal having a predetermined level to connect or disconnect the second lines L21, L22, L23, and L24 to or from each other. That is, when the first switch SW11 is turned on, the (2-1)-th line L21 and the (2-2)-th L22 may be connected to each other, when the second switch SW12 is turned on, the (2-2)-th line L22 and the (2-3)-th line L23 may be connected to each other, and when the third switch SW13 is turned on, the (2-3)-th line L23 and the (2-4)-th line L24 may be connected to each other.

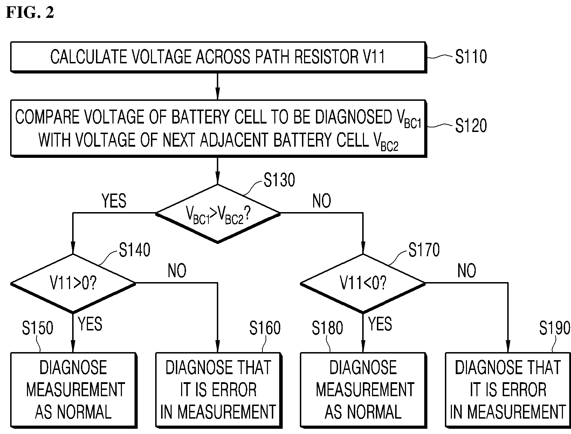

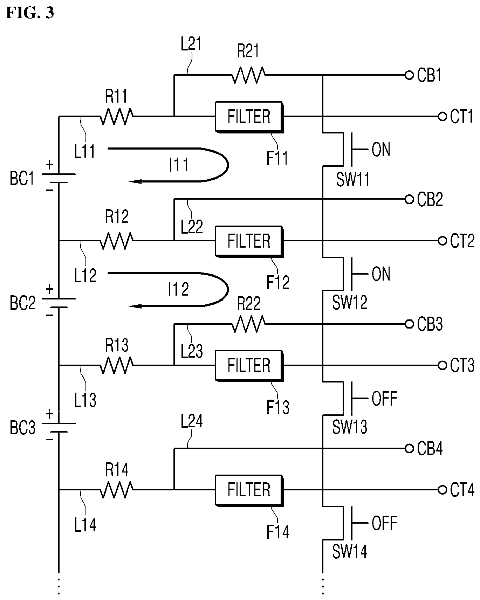

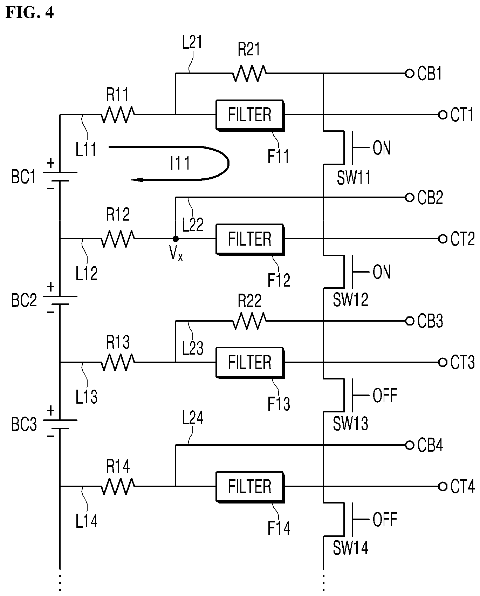

FIG. 2 is a flowchart of a method for diagnosing measurement of a battery cell voltage according to an embodiment of the present invention. In addition, FIGS. 3 and 4 are circuit diagrams for describing the method for diagnosing measurement of a battery cell voltage according to an embodiment of the present invention. That is, FIG. 3 is a circuit diagram for describing a current direction according to a magnitude of voltage of the battery cell to be diagnosed and that of the next adjacent battery cell, and FIG. 4 is a circuit diagram for describing a process of calculating a voltage across a path resistor according to the present invention.

Referring to FIG. 2, a method for diagnosing measurement of a battery cell voltage according to an embodiment of the present invention may include a voltage across a path resistor calculation process of calculating a voltage across a path resistor connected to an output path of a battery cell to be diagnosed from a voltage at an output end of the output path (S110), a process of comparing the battery cell voltage to be diagnosed $V_{BC1}$ with the next adjacent battery cell voltage $V_{BC2}$ (S120), a process of checking, when the voltage of the battery cell to be diagnosed $V_{BC1}$ is greater than the voltage of the next adjacent battery cell $V_{BC2}$ ($V_{BC1} > V_{BC2}$) as a result of the comparison (S130), whether a measured value of the voltage across the path resistor is a positive value (S140) and determining that it is a normal diagnosis if the measured value is a positive value (S150), and determining that it is an error in diagnosis if the measured value is a negative value (S160), and a process of checking, when the voltage of the battery cell to be diagnosed $V_{BC1}$ is less than the voltage of the next adjacent battery cell $V_{BC2}$ ($V_{BC1} < V_{BC2}$) as a result of the comparison, whether a measured value of the voltage across the path resistor is a negative value (S170) and determining that it is a normal diagnosis if the measured value is a negative value (S180), and determining that it is an error in diagnosis if the measured value is a positive value (S190).

Prior to describing the method for diagnosing measurement of the battery cell voltage according to an embodiment of the present invention, a current direction according to a voltage of two adjacent battery cells will be described using FIG. 3. FIG. 3 is a circuit diagram for describing the current direction according to the magnitude of voltage of a battery cell to be diagnosed and the next adjacent battery cell. Among the switches SW11, SW12, SW13, and SW14 to which a plurality of battery cells BC1, BC2, BC3, and BC4 are connected and which are connected to the second lines L21, L22, L23, and L24, for example, when the first and second switches SW11 and SW12 connected to the adjacent first and second battery cells BC1 and BC2 are turned on, current flows along each path. That is, the first current I11 flows along a path of the first battery cell BC1, and the second current I12 flows along a path of the second battery cell BC2. In this case, the direction of the current is determined according to the magnitude of voltage of the battery cells BC1 and BC2. For example, when the voltage of the first battery cell BC1 is greater than the voltage of the second battery cell BC2, current flows from the positive terminal of the first battery cell BC1 to the negative terminal of the first battery cell BC1 through the (1-1)-th resistor R11, the (2-1)-th resistor R21, and the (1-2)-th resistor R12. However, when the voltage of the first battery cell BC1 is greater than the voltage of the second battery cell BC2, the current flows in the opposite direction. Therefore, the present invention uses this principle to diagnose voltage measurement depending on whether the magnitude of the voltage across the path resistor is a positive value or negative value.

The method for diagnosing measurement of a battery cell voltage according to an embodiment of the present invention is described for each process as follows.

S110: Balancing of a battery cell to be diagnosed is performed to calculate a first voltage across a path resistor. For example, when a first battery cell BC1 is selected as a battery cell to be diagnosed, the first switch SW11 is turned on and the remaining switches SW12, SW13, and SW14 are turned off to balance the first battery cell BC1. In this case, the current I11 flows along a path shown in FIG. 4. That is, when the first switch SW11 is turned on for balancing of the first battery cell BC1, the current I11 flows from the positive terminal of the first battery cell BC1 to the negative terminal of the first battery cell BC1 through the (1-1)-th resistor R11, the (2-1)-th resistor R21, and the (1-2)-th resistor R12. Of course, this flow of current I11 is assumed when the voltage of the first battery cell BC1 is greater than the voltage of the second battery cell BC2. In this case, a voltage drop occurs due to the (1-2)-th resistor R12 and a voltage V11 is measured. That is, a voltage drop occurs between the first node N11 and the negative terminal of the first battery cell BC1. Therefore, the voltage V11 before and after balancing may be calculated as in [Equation 1] through a voltage difference before and after the current flows. Here, $V_x$ is a voltage value of the first node N11 where the (2-2)-th line L22 branches from the (1-2)-th line L12, and the voltage value of the first node N11 may be measured at a (1-2)-th measurement pin CT2.

[Equation 1]

$$V11 = V_x(balancing\ ON) - V_x(balancing\ OFF)$$

That is, the voltage across the path resistor V11 can be calculated by subtracting the voltage applied to the node when balancing of the battery cell to be diagnosed BC1 is not performed from the voltage applied to the node when balancing of the battery cell to be diagnosed BC1 is performed.

S120: The voltage of the battery cell to be diagnosed is compared with the voltage of the next adjacent battery cell. For example, when the first battery cell BC1 is the battery cell to be diagnosed, the voltage $V_{BC1}$ of the first battery cell BC1 is compared with the voltage $V_{BC2}$ of the second battery cell BC2 adjacent to the first battery cell BC1.

S130 and S140: When the voltage of the battery cell to be diagnosed is greater than the voltage of the next adjacent battery cell as a result of comparing the voltage of the battery cell to be diagnosed with the voltage of the next adjacent battery cell(S130), the value of the voltage across the first path resistor V11 is checked (S140). That is, it is checked whether the value of the first voltage across the path resistor V11 is a positive value.

S150 and S160: When a value of the first voltage across the path resistor V11 is a positive value, the measurement is diagnosed as normal (S150), and when it is a negative value, it is diagnosed as an error in measurement (S160).

S130 and S170: As a result of comparing the voltage of the battery cell to be diagnosed with the voltage of the next adjacent battery cell, when the voltage of the battery cell to be diagnosed is smaller than that of the next adjacent battery cell (S130), the value of the voltage across the path resistor V11 is checked (S170). That is, it is checked whether the value of the voltage across the path resistor V11 is a negative value.

S180 and S190: When the value of the voltage across the path resistor V11 is a negative value, the measurement is diagnosed as normal (S180), and if it is a positive value, it is diagnosed as an error in measurement (S190).

That is, in the present invention, it is determined, depending on the magnitude of voltage of the battery cell voltage to be diagnosed and that of the next adjacent battery cell, as normal diagnosis when a condition that if $V_{BC1} > V_{BC2}$, then V11 > 0, or a condition that if $V_{BC1} < V_{BC2}$, then V11 < 0 is satisfied, and it is determined as an error in diagnosis when the two conditions are not satisfied. That is, if the voltage of the battery cell to be diagnosed is greater than the voltage of the next adjacent battery cell, the measurement is diagnosed as normal when the voltage across the path resistor is a positive value. If the voltage of the battery cell to be diagnosed is less than the voltage of the next adjacent battery cell, the measurement is diagnosed as normal when the voltage across the path resistor is a negative value.

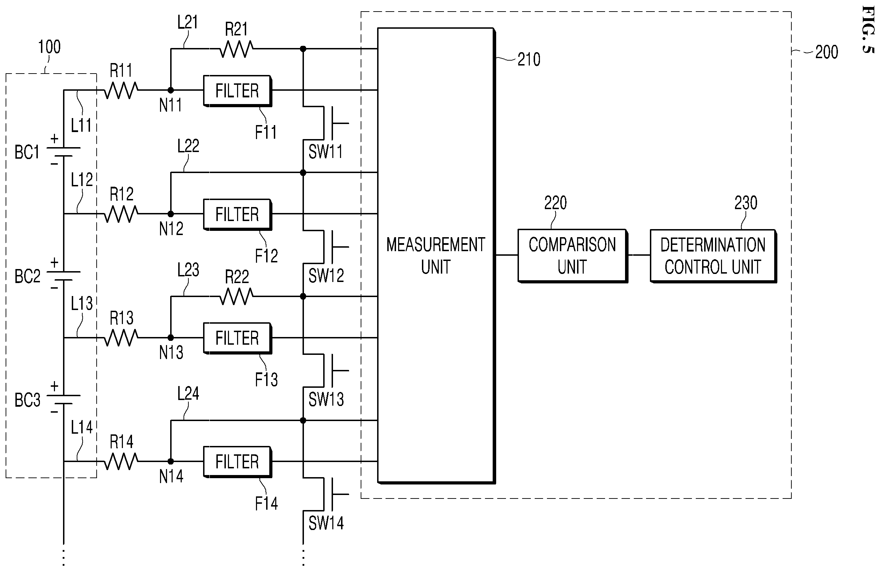

FIG. 5 is a block diagram for describing a configuration of a device for diagnosing measurement of a battery cell voltage according to an embodiment of the present invention. That is, the circuit for diagnosing measurement of a battery cell voltage of FIG. 1 may be connected to the diagnosis device to form a diagnosis device as shown in FIG. 5.

Referring to FIG. 5, a device for diagnosing measurement of a battery cell voltage according to an embodiment of the present invention may include a battery module 100 including a plurality of battery cells BC1, BC2, and BC3, and a diagnosis unit 200 that diagnoses an error in voltage measurement in a battery cell to be diagnosed. Here, the diagnosis unit 200 may be provided within the BMS. In addition, the diagnosis unit 200 may include a measurement unit 210 connected to a plurality of first measurement pins CT1, CT2, CT3, and CT4 and a plurality of second measurement pins CB1, CB2, CB3, and CB4 of the diagnosis circuit to measure the voltage, a comparison unit 220 that compares the voltage of the battery cell to be diagnosed with the voltage of the next adjacent battery cell and compares the measured values of the voltage across the path resistor accordingly, and a determination control unit 230 that generates control signals for controlling the switches SW11, SW12, SW13, and SW14 and determines a diagnosis result for measurement according to the comparison results of the comparison unit 220.

The measurement unit 210 is connected to a plurality of first measurement pins CT1, CT2, CT3, and CT4 and a plurality of second measurement pins CB1, CB2, CB3, and CB4. This measurement unit 210 measures a voltage through the plurality of first measurement pins CT1, CT2, CT3, and CT4 and the plurality of second measurement pins CB1, CB2, CB3, and CB4. That is, the measurement unit 210 may measure the voltage of the battery cell to be diagnosed through the first measurement pins CT1, CT2, CT3, and CT4 and the second measurement pins CB1, CB2, CB3, and CB4 that are connected to the battery cell to be diagnosed. In addition, the measurement unit 210 according to the present invention may measure the voltage when cell balancing of a specific battery cell is performed and the voltage when cell balancing of the corresponding battery cell is not performed. That is, the measurement unit 210 measures the voltage when balancing of the battery cell to be diagnosed is performed and the voltage when balancing of the battery cell to be diagnosed is performed is not performed, and calculates the first voltage across the path resistor V11 accordingly.

The comparison unit 220 compares the voltage of the battery cell to be diagnosed with the voltage of the next adjacent battery cell. In addition, the comparison unit 220 compares the value of the voltage across the path resistor according to the comparison result between the voltage of the battery cell to be diagnosed and the voltage of the next battery cell. That is, the comparison unit 220 calculates the voltage across the path resistor of the battery cell to be diagnosed. In this case, the voltage across the path resistor can be calculated by performing subtraction between the voltage when battery cell balancing is performed and the voltage when the battery cell balancing is not performed.

The determination control unit 230 determines a result of diagnosing the measurement according to the value of the voltage across the path resistor according to the comparison result of the comparison unit 220. That is, according to the comparison result of the comparison unit 220, the determination control unit 230 diagnoses the measurement as normal when the voltage of the battery cell to be diagnosed is greater than the voltage of the next adjacent battery cell and the voltage across the path resistor has a positive value, and diagnoses it as an error in measurement when the voltage across the path resistor has a negative value. In addition, the determination control unit 230, according to the comparison result of the comparison unit 220, diagnoses the measurement as normal when the voltage of the battery cell to be diagnosed is less than the voltage of the next adjacent battery cell and the voltage across the path resistor has a negative value, and diagnoses it as an error in measurement when the voltage across the path resistor has a positive value. In this case, when it is diagnosed as an error in measurement, it may be determined that at least one of the plurality of first measurement pins CT1, CT2, CT3, and CT4 and the plurality of second measurement pins CB1, CB2, CB3, and CB4 is abnormal, or an abnormality has occurred in the circuit. Meanwhile, the determination control unit 230 may generate control signals for controlling the switches SW11, SW12, SW13, and SW14 to control the switches SW11, SW12, SW13, and SW14. That is, the determination control unit 230 may select a battery cell to be diagnosed and control a switch connected to a measurement pin of the corresponding battery cell so that balancing of the battery cell is performed. In addition, the determination control unit 230 may control switches connected to two battery cells in order to allow the voltage of the battery cell to be diagnosed and the voltage of the next adjacent battery cell to be measured.

.As described above, in the method for diagnosing measurement of a battery cell voltage according to an embodiment of the present invention, the voltage of the battery cell to be diagnosed is compared with the voltage of the next adjacent battery cell, and when the voltage of the battery cell to be diagnosed is greater than the voltage of the next adjacent battery cell, if the voltage across the path resistor is a positive value, the measurement is determined to be a normal measurement. When the voltage of the battery cell to be diagnosed is less than the voltage of the next adjacent battery cell, if the voltage across the path resistor is a negative value, the measurement is determined to be a normal measurement. In this case, the voltage across the path resistor can be calculated by measuring the voltage across the path resistor when balancing of the battery cell to be diagnosed is performed, measuring the voltage across the path resistor when balancing thereof is not performed, and performing subtraction between the voltages across the path resistor.

The conventional method has a problem in that an abnormality in the battery cell voltage measurement circuit cannot be diagnosed when both lines connected to one terminal of the battery cell are abnormal. However, in the present invention, by comparing the voltage of the battery cell to be diagnosed with the voltage of the next adjacent battery cell and diagnosing an error in measurement according to the value of the voltage across the path resistor, the error in measurement can be diagnosed even when both lines connected to one terminal of the battery cell are abnormal or one of the two lines is abnormal. That is, according to the present invention, it is possible to solve the problem of the conventional method of not being able to diagnose an abnormality in the battery cell voltage measurement circuit when both lines connected to one terminal of the battery cell are abnormal.

The technical idea of the present invention as described above has been described in detail according to the above-mentioned embodiments, but it should be noted that the above-described embodiments are for its description and not intended to limit it. In addition, those skilled in the art will understand that various embodiments are possible within the scope of the technical idea of the present invention.

The names of reference numerals used in the description and drawings of the invention are as follows

    BC1, BC2, BC3: battery cell
    L11, L12, L13, L1: first line
    L21, L22, L23, L24: second line
    R11, R12, R13, R14: first resistor
    R21, R22: second resistor
    SW11, SW12, SW13, SW14: switch
    100: battery module
    200: BMS
    210: measurement unit
    220: comparison unit
    230: determination control unit

**Claims**

1. A method for diagnosing measurement of a battery cell voltage, comprising:

   a process of calculating a voltage across a path resistor connected to an output path of a battery cell to be diagnosed;
   a process of comparing a voltage of the battery cell to be diagnosed with a voltage of a next adjacent battery cell; and
   a process of diagnosing an error in measurement according to the comparison result and a value of the voltage across the path resistor.

2. The method of claim 1, wherein
   the voltage across the path resistor is calculated from a difference between a voltage measured in a state that a balancing path of the battery cell to be diagnosed is set and a voltage measured in a state that the balancing path thereof is not set.

3. The method of claim 2, wherein
   when the voltage of the battery cell to be diagnosed is greater than the voltage of the next adjacent battery cell and the voltage across the path resistor is a positive value, the measurement is diagnosed as normal, and when the voltage of the battery cell to be diagnosed is less than the voltage of the next adjacent battery cell and the voltage across the path resistor is a negative value, the measurement is diagnosed as normal.

4. The method of claim 3, wherein
   the remaining cases except for a case where the measurement is diagnosed as normal according to the comparison result of the voltage of the battery cell to be diagnosed and the voltage of the next adjacent battery cell and the value of the voltage across the path resistor are diagnosed as an error in measurement.

5. A method for diagnosing measurement of a battery cell voltage of a battery pack including a plurality of battery cells and a BMS, comprising:

   a process of calculating a voltage across a path resistor connected to an output path of a battery cell to be diagnosed from a voltage at an output end of the output path;
   a process of comparing a voltage of the battery cell to be diagnosed with a voltage of the next adjacent battery cell, and diagnosing measurement as normal when the comparison result and the voltage across the path resistor are included in set values; and
   a process of diagnosing that it is an error in voltage measurement when the measurement is not diagnosed as normal.

6. The method of claim 5, wherein
   the voltage across the path resistor is calculated from a difference between a voltage when balancing of the battery cell to be diagnosed is performed and a voltage when the balancing thereof is not performed.

7. The method of claim 6, wherein
   when the voltage of the battery cell to be diagnosed $V_{BC1}$, the voltage of the next adjacent battery cell $V_{BC2}$, and the voltage across the path resistor voltage V11 satisfy a condition that if $V_{BC1} > V_{BC2}$, then V11 > 0, or satisfy a condition that if $V_{BC1} < V_{BC2}$, then V11 < 0, the measurement is diagnosed as normal, and otherwise, it is diagnosed as an error in measurement.

**FIG. 1**

**FIG. 2**

CALCULATE VOLTAGE ACROSS PATH RESISTOR V11 — S110

COMPARE VOLTAGE OF BATTERY CELL TO BE DIAGNOSED $V_{BC1}$ WITH VOLTAGE OF NEXT ADJACENT BATTERY CELL $V_{BC2}$ — S120

S130

$V_{BC1}$>$V_{BC2}$?

YES

NO

S140

V11>0?

NO

S170

V11<0?

NO

S150 YES

S160

S180 YES

S190

DIAGNOSE MEASUREMENT AS NORMAL

DIAGNOSE THAT IT IS ERROR IN MEASUREMENT

DIAGNOSE MEASUREMENT AS NORMAL

DIAGNOSE THAT IT IS ERROR IN MEASUREMENT

**FIG. 3**

**FIG. 4**

FIG. 5

EP 4 764 536 A1

13

## INTERNATIONAL SEARCH REPORT

| International application No. |
| --- |
| **PCT/KR2024/011412** |

| A. | CLASSIFICATION OF SUBJECT MATTER |
| --- | --- |
| | **G01R 31/385**(2019.01)i; **G01R 19/165**(2006.01)i; **G01R 19/10**(2006.01)i; **G01R 35/00**(2006.01)i |

According to International Patent Classification (IPC) or to both national classification and IPC

| B. | FIELDS SEARCHED |
| --- | --- |

Minimum documentation searched (classification system followed by classification symbols)

G01R 31/385(2019.01); G01R 19/00(2006.01); G01R 31/02(2006.01); G01R 31/36(2006.01); G01R 31/382(2019.01); G01R 31/396(2019.01); H01M 10/42(2006.01); H01M 10/48(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 전압(voltage), 측정(measurement), 저항(resistor), 오류(error)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | JP 2007-327772 A (MATSUSHITA ELECTRIC IND CO., LTD.) 20 December 2007 (2007-12-20)<br>See claims 1-7 and figure 1. | 1-7 |
| A | KR 10-2022-0013167 A (LG ENERGY SOLUTION, LTD.) 04 February 2022 (2022-02-04)<br>See claims 1-12 and figure 1. | 1-7 |
| A | JP 2019-075933 A (TOSHIBA CORP. et al.) 16 May 2019 (2019-05-16)<br>See claims 1-7 and figure 3. | 1-7 |
| A | JP 2018-021803 A (DENSO TEN LTD.) 08 February 2018 (2018-02-08)<br>See claims 1-8 and figure 1A. | 1-7 |
| A | JP 2019-158539 A (DENSO CORP.) 19 September 2019 (2019-09-19)<br>See claims 1-5 and figure 1. | 1-7 |

☐ Further documents are listed in the continuation of Box C.  ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
| --- | --- |
| **08 November 2024** | **08 November 2024** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2024/011412**

| Patent document cited in search report | | | Publication date (day/month/year) | Patent family member(s) | | | Publication date (day/month/year) |
|---|---|---|---|---|---|---|---|
| JP | 2007-327772 | A | 20 December 2007 | JP | 4960022 | B2 | 27 June 2012 |
| KR | 10-2022-0013167 | A | 04 February 2022 | CN | 114981673 | A | 30 August 2022 |
| | | | | EP | 4083642 | A1 | 02 November 2022 |
| | | | | EP | 4083642 | B1 | 17 July 2024 |
| | | | | JP | 2023-502200 | A | 23 January 2023 |
| | | | | JP | 7347896 | B2 | 20 September 2023 |
| | | | | US | 2022-0390520 | A1 | 08 December 2022 |
| | | | | WO | 2022-019600 | A1 | 27 January 2022 |
| JP | 2019-075933 | A | 16 May 2019 | CN | 111095722 | A | 01 May 2020 |
| | | | | CN | 111095722 | B | 27 October 2023 |
| | | | | JP | 6789910 | B2 | 25 November 2020 |
| | | | | WO | 2019-078240 | A1 | 25 April 2019 |
| JP | 2018-021803 | A | 08 February 2018 | | None | | |
| JP | 2019-158539 | A | 19 September 2019 | CN | 110261780 | A | 20 September 2019 |
| | | | | CN | 110261780 | B | 28 June 2022 |
| | | | | JP | 7081225 | B2 | 07 June 2022 |
| | | | | US | 10871523 | B2 | 22 December 2020 |
| | | | | US | 2019-0277923 | A1 | 12 September 2019 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 101610908

- KR 1020230108604